(19) Europäisches Patentamt

European Patent Office

Office européen des brevets

(11) **EP 0 446 037 B1**

(12) **EUROPEAN PATENT SPECIFICATION**

(45) Date of publication and mention
of the grant of the patent:
**08.10.1997 Bulletin 1997/41**

(51) Int Cl.6: **H04B 1/66**

(21) Application number: **91301877.6**

(22) Date of filing: **06.03.1991**

(54) **Hybrid perceptual audio coding**

Hybride wahrnehmungsgebundene Kodierung von Audiosignalen

Codage perceptuel hybride de signaux audio

(84) Designated Contracting States:
**DE FR GB IT NL**

(30) Priority: **09.03.1990 US 491373**

(43) Date of publication of application:
**11.09.1991 Bulletin 1991/37**

(73) Proprietor: **AT&T Corp.**
**New York, NY 10013-2412 (US)**

(72) Inventors:
• **Brandenburg, Karlheinz**
**Stirling, New Jersey 07980 (US)**
• **Johnston, James David**
**Warren, New Jersey 07060 (US)**

(74) Representative:
**Buckley, Christopher Simon Thirsk et al**
**Lucent Technologies (UK) Ltd,**
**5 Mornington Road**
**Woodford Green, Essex IG8 0TU (GB)**

(56) References cited:
• **IEEE JOURNAL ON SELECTED AREAS IN COMMUNICATION. vol. 6, no. 2, February 1988, NEW YORK US pages 314 - 323; JOHNSTON: 'Transform Coding of Audio Signals Using Perceptual Noise Criteria'**
• **BELL SYSTEM TECHNICAL JOURNAL. vol. 56, no. 5, May 1977, NEW YORK US pages 747 - 769; CROCHIERE: 'On the Design of Sub-band Coders for Low-Bit-Rate Speech Communication'**
• **1984 INTERNATIONAL ZURICH SEMINAR ON DIGITAL COMMUNICATION March 1984, NY pages 7 - 13; WESTALL ET AL: 'Efficient Realizations of Digital Speech Coders for Telecommunications Applications'**

## Description

This invention relates to methods of processing an ordered time sequence of audio signals.

In recent years several advanced bit rate reduction algorithms for high quality digital audio have been proposed (see e.g., Schroeder, E.F. & Voessing, W.: "High quality digital audio encoding with 3.0 bits/sample using adaptive transform coding," 80th. AES-convention Montreaux 1986, Preprint 2321 (B2); Theile, G. & Link, M. & Stoll, G.: "Low bit rate coding of high quality audio signals," 82nd AES convention, London 1987, Preprint 2432 (C-1); Brandenburg, K.: "OCF - A new coding algorithm for high quality sound signals," in Proc. of the 1987 Int. Conf. on Acoust., Speech and Signal Proc. ICASSP 1987, pp. 141-144; and Johnston, J.D.: "Transform Coding of Audio Signals Using Perceptual Noise Criteria," IEEE Journal on Selected Areas in Communications, Vol. 6 (1988), pp. 314-323). Nearly transparent quality can be achieved at bit rates down to 64 kbit/sec. using frequency domain approaches (see e.g., Brandenburg, K. & Seitzer, D.: "OCF: Coding High Quality Audio with Data Rates of 64 kbit/sec," 85th AES convention, Los Angeles 1988; Johnston, J.D.: "Perceptual Transform Coding of Wideband Stereo signals," pp. 1993-1996, ICASSP 1989; and Theile, G. & Stoll, G. & Link, M.: "Low bit-rate coding of high quality audio signal. An introduction to the MASCAM system," EBU Review- Technical, No. 230 (August 1988), pp. 71-94).

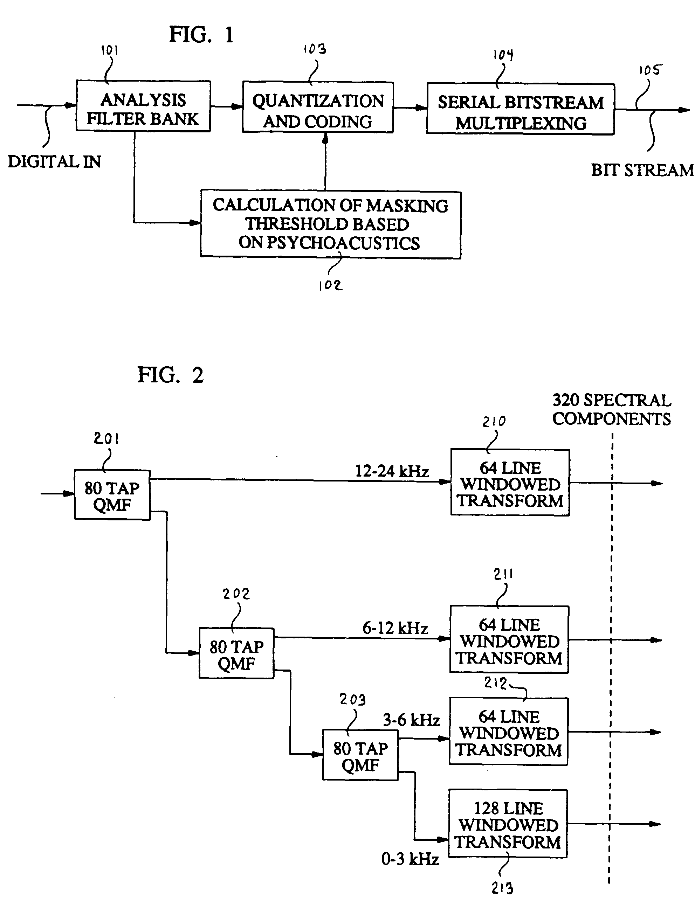

FIG. 1 shows the basic block diagram common to all perceptual frequency domain coders.

A filterband 101 is used to decompose the input signal into subsampled spectral components. The subsampled spectral components are then used to calculate an estimate of the actual (time dependent)) masking threshold in block 102 using rules known from psychoacoustics (see e.g., Zwicker, E.: "Psychoakustik" (in German), Berlin Heidelberg New York 1982; Hellman, R. P.: "Asymmetry of masking between noise and tone, Perception and Pyschophysics," Vol. 11, pp. 241-246, 1972; and Scharf, B : Chapter 5 of Foundations of Modern Auditory Theory, New York, Academic Press, 1970). The spectral components are then quantized and coded in block 103 with the aim of keeping the noise, which is introduced by quantizing, below the masking threshold. Depending on the algorithm this step is done in very different ways, from simple block companding to analysis by synthesis systems using additional noiseless compression.

Finally, a multiplexer 104 is used to assemble the bitstream, which typically consists of the quantized and coded spectral coefficients and some side information, e.g. bit allocation information.

There are two filterbank designs commonly used in the above arrangement. One type is the so-called tree-structured filterbank (see e.g. QMF filterbank; described in Jayant, N. S. & Noll, P.: Digital Coding of Waveforms: Principles and Applications to Speech and Video, Englewood Cliffs 1984) which are designed with the filter bandwidth of the individual bands set according to the critical bands as known from psychoacoustics. Also known are those filter banks used in transform coders (see e.g., Jayant, N. S. & Noll, P.: above, and Zelinski, R. & Noll, P., "Adaptive Transform Coding of Speech Signals," IEEE Trans. on Acoustics, Speech and Signal Processing, ASSP-25 (1977), pp. 299-309) which use a windowed transform to implement a filter bank with equal bandwidth filters with low computational complexity. Transform coders typically calculate 128 to 1024 spectral components, which also can be grouped by critical bands.

The basic problem of the design of an analysis/synthesis system for use in high quality digital audio coding is the trade-off between time domain and frequency domain behavior: If more spectral components are used, the masking functions can be estimated with better accuracy. In addition, a higher decorrelation of the spectral components, and therefore a higher coding gain, can be achieved. On the other hand, a higher spectral resolution necessitates less time resolution, which leads to problems with preechoes (see e.g., Vaupelt, Th.: "Ein Kompander zur Unterdrueckung von hoerbaren Stoerungen bei dynamischen Signalpassagen fuer ein Transfor- mationscodierungsverfahren fuer qualitative hochwertige Audiosignale (MSC)", (in German), ITG Fachbericht 106, pp. 209-216; and Brandenburg, K.: "High quality sound coding at 2.5 bit/sample," 84th AES Convention, Paris 1988, Preprint 2582) and longer processing delay.

According to this invention there is provided a method as claimed in claim 1.

The present invention provides structure and methods which seek to overcome the limitations of the prior art through a closer match to the processing of audio signals by the human ear. More specifically, the present invention models the ear as a filterbank, but with differing time and frequency resolution at different frequencies. Thus the present invention provides an analysis framework that achieves a better fit to the human ear.

An embodiment of a hybrid coder, uses a quadrature mirror filter to perform an initial separation of input audio signals into appropriate frequency bands. This filtered output is again filtered using a windowed transform to achieve the effect of a computationally effective filter bank with many channels.

Masking thresholds for the filtered signals are then determined using a "superblock" technique. As in earlier work by the present inventors, a "tonality" measure is used in actually developing appropriate masking thresholds. In the present invention, however, an improved tonality measure that is local to critical bands, or even a single spectral line, is used. Advantageously, well known OCF coding and quantization techniques are then used to further process the perceptually coded signals for transmission or storage.

## Brief Description of the Drawing

FIG. 1 shows a general block diagram of a perceptual coder;
FIG. 2 shows a basic analysis system used in the hybrid coder in the context of a system of the type of the type shown in FIG. 1;
FIG. 3 shows a time/frequency breakdown of the hybrid analysis structure of FIG. 2;
FIG. 4 shows a short time spectrum of a test signal; and
FIG. 5 shows a block diagram of the iteration loops of a typical implementation.

## Detailed Description

### THE NEW ANALYSIS/SYNTHESIS FILTERBANK

The hybrid coder in accordance with an illustrative embodiment uses a hybrid QMF/Transform filterbank. FIG. 2 shows the basic analysis/synthesis system. The time domain values are first filtered by a conventional QMF-tree filterbank 201-203. This filterbank is used to get 4 channels with 3 to 12 kHz bandwidth (frequency resolution) and accordingly, 2 to 8 sample time resolution. The QMF filterbank was chosen only because optimized filters were readily available that satisfied our design goals. It proves convenient to use 80-tap QMF filters derived from Johnston, J. D., *"A Filter Family Designed for Use in Quadrature Mirror Filter Banks*," ICASSP 1980, pp. 291-294). This 80-tap filter is clearly an overdesign; lower computational complexity will clearly suffice.

It is well known that classical QMF-tree filterbanks do not yield "perfect reconstruction" of the input signal. However, 80 tap filter illustratively used yields near perfect reconstruction of the analysis/synthesis filter bank in the sense that the sum of the pass band ripple is below 16 bit resolution. Thus, rounding leads to perfect reconstruction.

The output signals of the QMF-tree are filtered again, this time using a windowed transform to get a computational effective filter bank 210-213 with many channels. The window used is a sine window, using 50 % overlap of the analysis blocks. Two different transforms have been used for this purpose. The first transform that may be used is a classical DFT, which calculates 65 or 129 (lowest frequencies) complex lines. In this approach the analysis- synthesis filterbank is not critically sampled. On the other hand, prediction of the complex frequency lines can be easily used to reduce the data rate further. Alternatively, a modified DCT (MDCT) as used in Brandenburg, K.: "Ein Beitrag zu den Verfahren und der Qualitaetsbewteilung fuer hochwertige Musikcodierung," (in German), Ph.D. thesis, Universitaet Erlangen-Nuernberg 1989 and described first in Princen, J. & Johnson, A., Bradley, A.: "Subband / Transform Coding Using Filter Bank Designs Based on Time Domain Aliasing Cancellation", in Proc. of the 1987 Int. conf. on Acoustics, Speech and Signal Processing ICASSP 87, pp. 2161-2164 may be used. This technique calculates 64 or 128 frequency values per subband and is critically sampled. Using this MDCT approach, only half the samples have to be quantized and encoded as compared to the DFT solution.

The combined filterbank has a frequency resolution of 23.4 Hz at low frequencies and 187.5 Hz at high frequencies, with a corresponding difference in time resolution. While the time resolution is illustratively quantized to powers of 2, advances in the analysis/synthesis method will provide more range in time/frequency resolution as well as less quantization. Depending on the frequency band, the characteristics of the filter bank are similar to an MDCT filterbank of block length 1024 at low frequencies and 128 at high frequencies. Thus, the frequency resolution at low frequencies is sufficient for the perceptual model, and the time resolution at high frequencies is short enough for pre-echo control without additional algorithmic accommodation. Table 1 shows time and frequency resolution values for the combined filter bank used in the hybrid coder.

Table 1:

| Time and frequency resolution of the analysis/synthesis filterbank | | | | |
|---|---|---|---|---|
| Lower bound in Frequency | Upper bound in Frequency | Frequency Resolution | Time Resolution | Time Resolution |
| Hz | Hz | Hz | samples | mS |
| 0.0 | 3000. | 23.4 | 1024 | 21.3 |
| 3000. | 6000. | 46.8 | 512 | 10.7 |
| 6000. | 12000. | 93.6 | 256 | 5.3 |
| 12000 | 24000 | 187.2 | 128 | 2.7 |

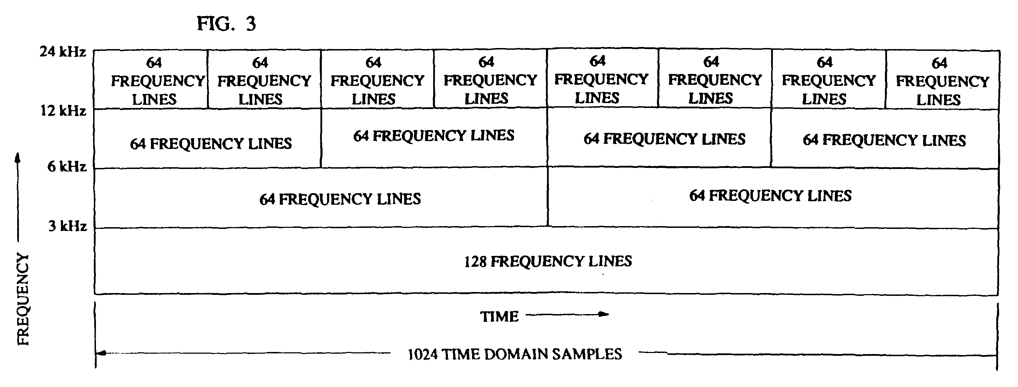

The masking threshold is estimated using the structure of the output signal of the filterbank. The computation is done for "superblocks" containing eight "time slices" corresponding to the number of high-frequency transforms in the low-frequency transform interval. The signal energy in the lower frequency band is distributed equally between the 8 time slices, and that of the middle frequencies distributed according to their transform rate. The "superblock" allocation is shown in FIG. 3.

Then the threshold is calculated for each of the 8 time slices using improved methods similar to those in Johnston, J.D.: "Transform Coding of Audio Signals Using Perceptual Noise Criteria," IEEE Journal on Selected Areas in Communications, Vol. 6 (1988), pp. 314-323. The threshold values for transforms spread across more than 1 time slice are then added up, to give the estimate of the masking threshold with the appropriate time resolution for the critical bands contained in each transform block. Critical band boundaries are aligned with the subband boundaries, resulting in 25 critical bands.

The actual quantizer and coder must add no more noise than indicated by the estimated masking threshold in order to code the signal transparently, according to the threshold model.

## CALCULATION OF TONALITY

Different values for the masking threshold for narrow band signals have been reported in literature for tone masking noise and noise as a masker. See e.g., the Hellman and Scharf references, above. In the Johnston reference, above, the spectral flatness measure was used to calculate a global "tonality" of the short time spectrum of the signal. This tonality measure was then used to interpolate between the masking threshold formulas from Hellman and Scharf. A problem has been found with the notion of a global tonality:

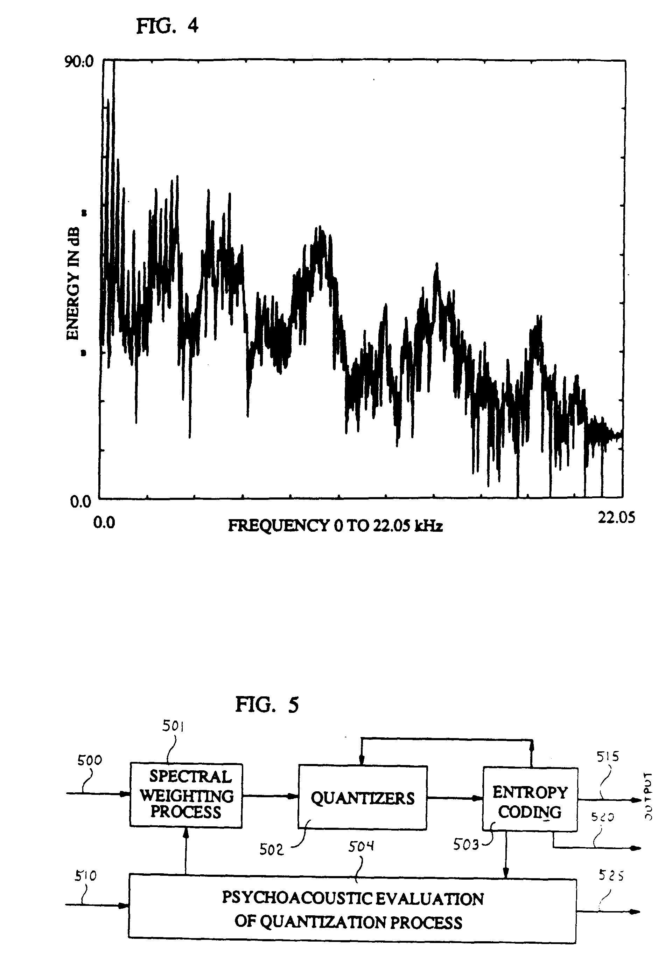

Some signals, especially speech signals or an "a capella" singer (see FIG. 4), show a spectrum with "tonal" parts (low harmonics of the pitch frequencies) and "noisy" parts of considerable energy at high frequencies. The result of the measurement of a global spectral flatness measure will not show that parts of the signal are very tonal (i.e., coherent from transform block to transform block). Further, i.e., even if the tonality is estimated correctly for the sensitive (tonal) parts of such a signal, the formula previously used will lead to a very conservative masking threshold at high frequencies, thereby requiring an excessive bit rate.

Experiments with changed estimated masking thresholds and results of the different approach to the estimation of the masking threshold taken in Brandenburg, K.: "Ein Beitrag zu den Verfahren und der Qualitaetsbeurteilung fuer hochwertige Musikcodierung," (in German), Ph.D. thesis, Universitaet Erlangen-Nuernberg 1989, caused a search for a new tonality measure.

As used in one aspect of the present invention to estimate the amount of masking by a signal tonality, is modeled not as a global value, but as a characteristic local to a critical band or even a single spectral line. In the context of the illustrative hybrid coder, this local tonality is estimated by a coherence measure:

For each spectral component (= subband or transform coefficient) a coherence measure is calculated. This is done using a simple prediction, calculated in polar coordinates in the complex plane. Several predictors were tested, and the one described below was selected on the basis of performance.

Let $r(t,f)$ be the radius of the spectral value at time $t$ and frequency $f$ and $\phi(t,f)$ the phase value at $t$ and $f$.

The predicted value of $r$ and $\phi$ at time $t$ are calculated as:

$$\hat{r}(t,f) = r(t-1,f) + (r(t-1,f) - r(t-2,f))$$

and

$$\hat{\phi}(t,f) = \phi(t-1,f) + \phi(t-1,f) - \phi(t-2,f)$$

The Euclidean distance between the actual and predicted values is used to get the new tonality metric, $c(t,f)$. Then,

$$c(t,f) = \frac{\text{dist}\,((\,\hat{r}(t,f),\hat{\phi}(t,f)\,),(\,r(t,f),\phi(t,f)\,))}{(\,r(t,f) + \text{abs}\,(\hat{p}(t,f)\,))}$$

If the prediction turns out to be very good, $c(t,f)$ will have values near zero. On the other hand, for very unpredictable (noisy) signals $c(t,f)$ will have values of up to 1 with a mean of 0.5. This "inverse tonality" or "measure of chaos" is converted to a tonality metric by a simple log-linear operation.

$$t = \alpha \ln c + \beta$$

The new tonality metric is used to estimate the masking threshold at each spectral component in the same way as described in the Johnston paper cited above for the old tonality metric. The program in Listing 1 illustrates the processing used to form c(t,f) in the context of a 512 sample input sequence. The program of Listing 1 is written in the well-known FORTRAN programming language described, e.g., in Fx/FORTRAN Programmer's Handbook, Alliant Computer Systems Corp., 1988. The program is intended for use on general purpose computers marketed by Alliant Computer Systems Corp., but may be readily adapted for use on other general purpose or special purpose processors.

In a typical version of the hybrid coder in accordance with the present teachings, the quantization and coding scheme of the OCF (Optimum Coding in the Frequency domain), system described in Brandenburg, K. & Seitzer, D.: "OCF: Coding high Quality Audio with Data Rates of 64 kbit/sec," 85th AES convention, Los Angeles 1988, has been used. In that analysis-by-synthesis scheme the spectral components are first quantized using a nonuniform quantizer. In the inner iteration loop (rate loop) the count of bits needed to code the quantized values using an entropy code is compared to the number of available bits. Depending on the ratio of actual over available bits the quantization step size is adjusted, leading to a different number of bits needed to code the block of quantized values. The outer iteration loop (distortion control loop) compares actual quantization noise energy for each critical band with the estimated masking threshold. If the actual noise exceeds the masking threshold in some critical band, the scale of the spectral components in this critical band is adjusted to yield a lower quantization noise. FIG. 5 shows a block diagram of the iteration loops used for quantization and coding. The algorithm is described in more detail in the papers by Johnston and Brandenburg and Seitzer, as well as the Brandenburg thesis, all cited above. FIG. 5 shows the manner in which a coder such as the OCF system uses the psychoacoustic threshold and related information described above to produce the actual bitstream to be transmitted or stored. Thus, input information on input 500 is assumed to have been appropriately buffered, partitioned into convenient blocks and transformed in the manner described above. The appropriate variable resolution spectral information is also provided to block 504 which provides the psychoacoustic evaluation for weighting frequency signals in block 501 prior to quantization in block 502. The actual entropy coding is represented by block 503 in FIG. 5. Thus the information describing the spectral information of the input signals is provided on output 515. Side information describing the cycle acoustic evaluation and quantizing processes is then supplied on outputs 520 and 525. All outputs are conveniently multiplexed into a single bit stream for transmission or storage.

The Perceptual Entropy (see e.g., Johnston, James D., "Estimation of Perceptual Entropy Using Noise Masking Criteria," ICASSP '88, pp. 2524-2527) is an estimate of the information content of a piece of music relative to the capabilities of the human auditory system. It gives an estimate of the minimum bit rate necessary for total transparent coding of a piece of music using a given analysis/synthesis scheme. As introduced in this last-cited paper by Johnston, the PE is calculated from the number of quantization levels necessary to code a piece of music at the masking threshold.

Using the analysis/synthesis frame work of the hybrid coder, estimates of the PE have been calculated for different pieces of music. Table 2 lists some of the results and compares them to the PE measured using other analysis/synthesis systems. It can be seen that the hybrid coder performs well compared to the older results.

Table 2:

| Results of PE measurements | | |
| --- | --- | --- |
| music (type) | Old PE (bits/sample) | New PE (bits/sample) |
| organ | .24 | .48 |
| suzanne vega | .69 | .54 |
| castanets | .73 | .52 |

Using the quantization/coding scheme of OCF as described above, typical results for the hybrid coder have been gathered. The bit rate used was 64 kbit/sec. per channel and the basic block length was 1024 time domain samples. The MDCT was used to compute the output of the combined filter bank from the QMF tree. The sampling rate of the test pieces was 48 kHz. The signals were coded with a bandwidth of up to 20 kHz. Out of the 1362 bits available for each block at 64 kb/s, 226 bits were used to code side information.

A second generation perceptual coder using enhanced time/frequency resolution has been described. A tonality metric, calculated on a frequency by frequency basis, is combined with the calculation of the coder's noise threshold at each frequency in order to provide a greatly improved threshold value. The present invention thus provides performance that compares favorably with known coding of high quality digital audio at low bit rates.

A decoder in accordance with the above teaching can be constructed by using the approach described above. Because of the enhanced time/frequency resolution provided by the present invention, corresponding enhanced processing is accomplished at a decoder.

Information used at a receiver or decoder to reconstruct the original input signal at the coder is, of course, that provided as outputs from the system represented by FIG. 5. In particular, the spectral information and side information, after demultiplexing if required, is used to reconstruct the original input signal. With the information describing the cycle acoustic evaluation and quantizing process, including global gain, quantizer step size, scaling factors, bit allocations and the like, all information necessary to reconstruct the sampled time domain signal from its frequency components is present at the receiver/decoder. Information about the non-uniform frequency and time resolution (both as a function of frequency) will also be used at the decoder. Well known digital to analog conversion will also be provided when it is required to create equivalent analog signals for reproduction of the original analog signal with high fidelity, e.g., on a loudspeaker.

## LISTING 1

```
c       First startup routine
        subroutine strt()
c       sets up threshold generation tables, ithr and bval
        real freq(0:25)/0.,100.,200.,300.,400.,510.,630.,770.,
       1 920.,1080.,1270.,1480.,1720.,2000.,2320.,2700.,
       1 3150.,3700.,4400.,5300.,6400.,7700.,9500.,12000.,15500.,
       1 25000./
        common/thresh/ithr(26),bval(257),morm(257)
        common/absthr/abslow(257)
        common/sigs/ifirst
c       ithr(i) is bottom of crital band i.   bval is  bark index
c       of each line

        write(*,*) 'what spl will +-32000 be -> '
        read(*,*) abslev
        abslev=abslev-96.


        abslow=5224245.*5224245./exp(9.6*alog(10.))



        ifirst=0

        write(*,*) 'what is the sampling rate'
        read(*,*) rzotz

        fnyq=rzotz/2.
c       nyquest frequency of interest.


        ithr(1)=2.
        i=2
10      ithr(i)=freq(i-1)/fnyq*256.+2.
        i=i+1
        if (freq(i-1) .lt. fnyq) goto 10
```

```
c          sets ithr to bottom of cb
           ithr(i:26)=257


c          now, set up the critical band indexing array

           bval(1)=0

c          first, figure out frequency, then ...

           do i=2,257,1

           fre=(i-1)/256.*fnyq
c          write(*,*) i,fre

c          fre is now the frequency of the line.  convert
c          it to critical band number..

           do j=0,25,1

           if ( fre .gt. freq(j) ) k=j
           end do
c          so now, k = last CB lower than fre
           rpart=fre-freq(k)
           range=freq(k+1)-freq(k)
           bval(i)=k+rpart/range
           end do

           morm=1

           do i=2,257,1
           tmp=0
           do j=2,257,1
           tmp=tmp+sprdngf(bval(j),bval(i))

           end do
```

```
        morm(i)=tmp
        end do

        morm=1./morm

c       do i=1,257,1
c       write(*,*) i, bval(i), 10.*alog10(morm(i))
c       end do

        call openas(0,'/usr/jj/nsrc/thrtry/freqlist',0)

        do i=2,257,1
        read(0,*) ii,db
        if ( ii .ne. i ) then
        write(*,*) 'freqlist is bad.'
        stop
        end if

        db=exp((db-abslev)/10.*alog(10.))
c       write(*,*) i,db
        abslow(i)=abslow(i)*db
        end do

        abslow(1)=1.
        write(*,*) 'lowest level is ', sqrt(abslow(45))

        return
        end


c       Threshold calculation program
        subroutine thrgen(rt,phi,thr)
        real r(257),phi(257)
        real rt(257)
        real thr(257)
        common/blnk/ or(257),ophi(257),dr(257),dphi(257)
```

```
common/blk1/othr(257)
real alpha(257),tr(257),tphi(257)
real beta(257),bcalc(257)
common/absthr/abslow(257)

common/thresh/ithr(26),bval(257),rnorm(257)
common/sigs/ifirst


r=max(rt,.0005)
bcalc=1.

if (ifirst .eq. 0) then
or=0.
othr=1e20
ophi=0
dr=0
dphi=0
ifirst=1
end if

c       this subroutine figures out the new threshold values
c       using line-by-line measurement.

tr=or+dr
tphi=ophi+dphi

dr=r-or
dphi=phi-ophi

or=r
ophi=phi

alpha=sqrt((r*cos(phi)-tr*cos(tphi))
1 *(r*cos(phi)-tr*cos(tphi))
2 +(r*sin(phi)-tr*sin(tphi))
```

```
      3 *(r*sin(phi)-tr*sin(tphi)))
      4 / ( r + abs(tr) +1.)
        beta=alpha
c       now, beta is the unweighted tonality factor


        alpha=r*r
c       now, the energy is in each
c       line.  Must spread.

c       write(*,*) 'before spreading'

        thr=0.
        bcalc=0.
cvd$l   cncall
        do i=2,257,1

cvd$l   cncall
        do j=2,257,1

        glorch=sprdngf(bval(j),bval(i))
        thr(i)=alpha(j)*glorch+thr(i)
        bcalc(i)=alpha(j)*glorch*beta(j)+bcalc(i)
c       thr is the spread energy, bcalc is the weighted chaos
        end do
c       if (thr(i) .eq. 0 ) then
c       write(*,*) 'zero threshold,'
c       stop
c       end if
        bcalc(i)=bcalc(i)/thr(i)
        if (bcalc(i) .gt. .5) bcalc(i)=1.-bcalc(i)
c       that normalizes bcalc to 0-.5
        end do


c       write(*,*) 'after spreading'
        bcalc=max(bcalc,.05)
```

```
          bcalc=min(bcalc,.5)
c         bcalc is now the chaos metric, convert to the
c         tonality metric

          bcalc=-.43*alog(bcalc)-.299
c         now calculate DB

          bcalc=max(24.5,(15.5+bval))*bcalc+5.5*(1.-bcalc)

          bcalc=exp( (-bcalc/10.) * alog (10.) )
c         now, bcalc is actual tonality factor, for power
c         space.

          thr=thr*rnorm*bcalc
c         threshold is tonality factor times energy (with normalization)
          thr=max(thr,abslow)
          alpha=thr
          thr=min(thr,othr*2.)
          othr=alpha
c         write(*,*) 'leaving thrgen'
          return
          end


c         And, the spreading function
          function sprdngf(j,i)
          real i,j
          real sprdngf
c         this calculates the value of the spreading function for
c         the i'th bark, with the center being the j'th
c         bark
          temp1=i-j
          temp2=15.811389 +7.5*(temp1+.474)
          temp2=temp2- 17.5*sqrt(1.+ (temp1+.474)*(temp1+.474) )
          if ( temp2 .le. -100. ) then
          temp3=0.
          else
```

```
temp2=temp2/10.*alog(10.)
temp3=exp(temp2)
end if
sprdngf=temp3
return
end
```

TABLE I

| | Absolute Threshold File ("freqlist" for start-up routine) | | | | | | | |
|---|---|---|---|---|---|---|---|---|
| 1 | | 56 | 3. | 111 | 16. | 166 | 16. | 221 | 50. |
| 2 | 27. | 57 | 4. | 112 | 17. | 167 | 16. | 222 | 50. |
| 3 | 18. | 58 | 4. | 113 | 17. | 168 | 16. | 223 | 50. |
| 4 | 16. | 59 | 5. | 114 | 17. | 169 | 16. | 224 | 50. |
| 5 | 10. | 60 | 5. | 115 | 17. | 170 | 16. | 225 | 50. |
| 6 | 9. | 61 | 5. | 116 | 18. | 171 | 17. | 226 | 50. |
| 7 | 8. | 62 | 6. | 117 | 18. | 172 | 17. | 227 | 50. |
| 8 | 8. | 63 | 6. | 118 | 18. | 173 | 17. | 228 | 50. |
| 9 | 8. | 64 | 6. | 119 | 18. | 174 | 17. | 229 | 50. |
| 10 | 8. | 65 | 6. | 120 | 18. | 175 | 17. | 230 | 50. |
| 11 | 8. | 66 | 7. | 121 | 18. | 176 | 17. | 231 | 50. |
| 12 | 7. | 67 | 7. | 122 | 18. | 177 | 18. | 232 | 50. |
| 13 | 7. | 68 | 7. | 123 | 18. | 178 | 18. | 233 | 50. |
| 14 | 7. | 69 | 8. | 124 | 17. | 179 | 18. | 234 | 60. |
| 15 | 7. | 70 | 9. | 125 | 17. | 180 | 18. | 235 | 60. |
| 16 | 7. | 71 | 10. | 126 | 16. | 181 | 18. | 236 | 60. |
| 17 | 7. | 72 | 10. | 127 | 16. | 182 | 19. | 237 | 60. |
| 18 | 7. | 73 | 10. | 128 | 16. | 183 | 19. | 238 | 60. |
| 19 | 7. | 74 | 10. | 129 | 16. | 184 | 19. | 239 | 60. |
| 20 | 7. | 75 | 10. | 130 | 15. | 185 | 19. | 240 | 60. |
| 21 | 7. | 76 | 10. | 131 | 15. | 186 | 19. | 241 | 60. |
| 22 | 7. | 77 | 10. | 132 | 15. | 187 | 20. | 242 | 60. |
| 23 | 7. | 78 | 10. | 133 | 15. | 188 | 21. | 243 | 60. |
| 24 | 7. | 79 | 10. | 134 | 14. | 189 | 22. | 244 | 60. |
| 25 | 6. | 80 | 10. | 135 | 14. | 190 | 23. | 245 | 60. |
| 26 | 5. | 81 | 11. | 136 | 13. | 191 | 24. | 246. | 60. |
| 27 | 5. | 82 | 11. | 137 | 12. | 192 | 25. | 247 | 60. |
| 28 | 5. | 83 | 11. | 138 | 12. | 193 | 26. | 248 | 60. |
| 29 | 5. | 84 | 11. | 139 | 12. | 194 | 27. | 249 | 60. |
| 30 | 5. | 85 | 11. | 140 | 12. | 195 | 28. | 250 | 60. |

TABLE I   (continued)

| Absolute Threshold File ("freqlist" for start-up routine) | | | | | | | | | |
|---|---|---|---|---|---|---|---|---|---|
| 31 | 4. | 86 | 12. | 141 | 12. | 196 | 29. | 251 | 60. |
| 32 | 4. | 87 | 12. | 142 | 12. | 197 | 30. | 252 | 60. |
| 33 | 4. | 88 | 12. | 143 | 12. | 198 | 31. | 253 | 60. |
| 34 | 4. | 89 | 12. | 144 | 13. | 199 | 32 | 254 | 60. |
| 35 | 4. | 90 | 12. | 145 | 13. | 200 | 33. | 255 | 60. |
| 36 | 3. | 91 | 12. | 146 | 14. | 201 | 34. | 256 | 60. |
| 37 | 3. | 92 | 13. | 147 | 14. | 202 | 35. | 257 | 60. |
| 38 | 3. | 93 | 13. | 148 | 14. | 203 | 36. | | |
| 39 | 3. | 94 | 13. | 149 | 14. | 204 | 37. | | |
| 40 | 2. | 95 | 13. | 150 | 14. | 205 | 38. | | |
| 41 | 2. | 96 | 13. | 151 | 14. | 206 | 39. | | |
| 42 | 1. | 97 | 13. | 152 | 14. | 207 | 40. | | |
| 43 | 1. | 98 | 14. | 153 | 14. | 208 | 41. | | |
| 44 | 1. | 99 | 14. | 154 | 14. | 209 | 42. | | |
| 45 | 1. | 100 | 14. | 155 | 14. | 210 | 43. | | |
| 46 | 0. | 101 | 14. | 156 | 15. | 211 | 44. | | |
| 47 | 0. | 102 | 15. | 157 | 15. | 212 | 45. | | |
| 48 | 0. | 103 | 15. | 158 | 15. | 213 | 46. | | |
| 49 | 0. | 104 | 15. | 159 | 15. | 214 | 47. | | |
| 50 | 0. | 105 | 15. | 160 | 15. | 215 | 48. | | |
| 51 | 0. | 106 | 15. | 161 | 15. | 216 | 49. | | |
| 52 | 2. | 107 | 16. | 162 | 15. | 217 | 50. | | |
| 53 | 2. | 108 | 16. | 163 | 15. | 218 | 50. | | |
| 54 | 2. | 109 | 16. | 164 | 15. | 219 | 50. | | |
| 55 | 3. | 110 | 16. | 165 | 15. | 220 | 50. | | |

**Claims**

1. A method of processing an ordered time sequence of audio signals partitioned into a set of ordered blocks, each of the blocks having a discrete frequency spectrum including a first set of frequency coefficients, the method including, for each of the blocks, the steps of:

    filtering the first set of frequency coefficients into a plurality of frequency groups;
    determining a tonality metric for each frequency group, the tonality metric corresponding to the degree to which said time sequence of audio signals of the frequency group includes a tone-like quality;
    determining a noise masking threshold for the frequency coefficients in each frequency group based on the tonality metric, the noise masking threshold indicating the amount of quantization noise that can be introduced into a frequency group without affecting its tone-like quality; and
    quantizing at least one frequency coefficient in at least one of the frequency groups, the quantizing being based upon the corresponding noise masking threshold, CHARACTERISED IN THAT the filtering step includes filtering the first set of frequency coefficients into a plurality of frequency bands with a bank of filters (201, 202, 203) of a first type, each of the frequency bands representing a contiguous range of frequencies; and filtering at least one of the frequency bands into a plurality of frequency groups with at least one filter (210, 211, 212, 213) of a second type, each of the frequency groups including at least one frequency coefficient, wherein the filtering step filters said frequency coefficients with differing time and frequency resolutions at different frequencies to substantially approximate human auditory response.

2. A method as claimed in claim 1 wherein the first type of filter is a tree structured filter, and said second type of filter is a transform type of filter.

3. A method as claimed in claim 2 wherein the tree structured filter is a quadrature mirror filter, and said transform type filter is a modified discrete cosine transform filter.

4. A method as claimed in claim 2 wherein the tree structured filter is a quadrature mirror filter, and said transform type filter is a discrete Fourier transform filter.

5. A method as claimed in claim 1 wherein the tonality metric is generated based on a coherence measure.

6. A method as claimed in claim 5 wherein the coherence measure is based on a prediction, calculated in polar coordinates on the complex plane of a frequency coefficient at a particular time, the coherence measure corresponding to the Euclidean distance between the actual and predicted frequency coefficients.

7. A method as claimed in claim 6 wherein the frequency coefficients correspond to the frequency coefficients within a frequency band.

8. A method as claimed in claim 6 wherein the frequency coefficients correspond to the frequency coefficients within a frequency group.


**Patentansprüche**

1. Verfahren der Verarbeitung einer in eine Menge von geordneten Blöcken eingeteilten geordneten Zeitfolge von Audiosignalen, wobei jeder der Blöcke ein diskretes, eine erste Frequenzkoeffizientenmenge enthaltendes Frequenzspektrum aufweist und das Verfahren für jeden der Blöcke die folgenden Schritte enthält:

Filtern der ersten Frequenzkoeffizientenmenge, um sie in eine Mehrzahl von Frequenzgruppen aufzuteilen; Bestimmen einer Tonalitätsmetrik für jede Frequenzgruppe, wobei die Tonalitätsmetrik dem Grad entspricht, zu dem die besagte Zeitfolge von Audiosignalen der Frequenzgruppe eine tonartige Beschaffenheit aufweist; Bestimmen einer Rausch-Maskierungsschwelle für die Frequenzkoeffizienten in jeder Frequenzgruppe auf der Grundlage der Tonalitätsmetrik, wobei die Rausch-Maskierungsschwelle das Ausmaß des Quantisierungsrauschens anzeigt, das in eine Frequenzgruppe eingeführt werden kann, ohne ihre tonartige Beschaffenheit zu beeinflussen; und Quantisieren mindestens eines Frequenzkoeffizienten in mindestens einer Frequenzgruppe, wobei das Quantisieren auf der Grundlage der entsprechenden Rausch-Maskierungsschwelle erfolgt,

dadurch gekennzeichnet, daß bei dem Filterungsschritt die erste Frequenzkoeffizientenmenge mit einer Bank von Filtern (201, 202, 203) eines ersten Typs gefiltert wird, um sie in eine Mehrzahl von Frequenzbändern aufzuteilen, wobei jedes der Frequenzbänder einen zusammenhängenden Frequenzbereich darstellt, und mindestens eines der Frequenzbänder mit mindestens einem Filter (210, 211, 212, 213) eines zweiten Typs gefiltert wird, um es in eine Mehrzahl von Frequenzgruppen aufzuteilen, wobei jede der Frequenzgruppen mindestens einen Frequenzkoeffizienten enthält und der Filterungsschritt die besagten Frequenzkoeffizienten bei verschiedenen Frequenzen mit unterschiedlichen Zeit- und Frequenzauflösungen filtert, um im wesentlichen dem Ansprechverhalten des menschlichen Gehörs nahezukommen.

2. Verfahren nach Anspruch 1, wobei der erste Filtertyp ein Filter mit Baumstruktur und der besagte zweite Filtertyp ein Transformationsfilter ist.

3. Verfahren nach Anspruch 2, wobei das Filter mit Baumstruktur ein Quadratur-Mirror-Filter und das besagte Transformationsfilter ein modifiziertes Filter mit diskreter Cosinustransformation ist.

4. Verfahren nach Anspruch 2, wobei das Filter mit Baumstruktur ein Quadratur-Mirror-Filter und das besagte Transformationsfilter ein Filter mit diskreter Fouriertransformation ist.

5. Verfahren nach Anspruch 1, wobei die Tonalitätsmetrik auf der Grundlage eines Kohärenzmaßes erzeugt wird.

6. Verfahren nach Anspruch 5, wobei das Kohärenzmaß auf einer Prädiktion basiert, die in Polarkoordinaten in der komplexen Ebene eines Frequenzkoeffizienten zu einem bestimmten Zeitpunkt berechnet wird, wobei das Kohärenzmaß der Euklidischen Distanz zwischen den tatsächlichen und den Prädiktions-Frequenzkoeffizienten entspricht.

7. Verfahren nach Anspruch 6, wobei die Frequenzkoeffizienten den Frequenzkoeffizienten in einem Frequenzband entsprechen.

8. Verfahren nach Anspruch 6, wobei die Frequenzkoeffizienten den Frequenzkoeffizienten in einer Frequenzgruppe entsprechen.


**Revendications**

1. Procédé de traitement d'une séquence temporelle ordonnée de signaux audio partitionnés en un ensemble de blocs ordonnés, chacun des blocs ayant un spectre de fréquences discret comportant un premier ensemble de coefficients de fréquence, le procédé comportant, pour chacun des blocs, les étapes de:

   filtrage du premier ensemble de coefficients de fréquence en une pluralité de groupes de fréquences;
   détermination d'une métrique de tonalité pour chaque groupe de fréquences, la métrique de tonalité correspondant au degré auquel ladite séquence temporelle de signaux audio du groupe de fréquences comporte une qualité de tonalité;
   détermination d'un seuil de masquage de bruit pour les coefficients de fréquence dans chaque groupe de fréquences en fonction de la métrique de tonalité, le seuil de masquage de bruit indiquant la quantité de bruit de quantification qui peut être introduit dans un groupe de fréquences sans affecter sa qualité de tonalité; et quantification d'au moins un coefficient de fréquence dans au moins un des groupes de fréquences, la quantification étant basée sur le seuil de masquage de bruit correspondant, CARACTERISE EN CE QUE l'étape de filtrage comporte le filtrage du premier ensemble de coefficients de fréquence en une pluralité de bandes de fréquences avec un bloc de filtres d'un premier type, chacune des bandes de fréquences représentant une gamme contiguë de fréquences; et le filtrage d'au moins une des bandes de fréquences en une pluralité de groupes de fréquence avec au moins un filtre (210, 211, 212, 213) d'un deuxième type, chacun des groupes de fréquences comportant au moins un coefficient de fréquence, dans lequel l'étape de filtrage filtre lesdits coefficients de fréquence avec des résolutions de temps et de fréquence différentes à des fréquences différentes pour approximer substantiellement la réponse auditive humaine.

2. Procédé conformément à la revendication 1, dans lequel le premier type de filtre est un filtre structuré en arborescence, et ledit deuxième type de filtre est un filtre du type par transformée.

3. Procédé conformément à la revendication 2, dans lequel le filtre structuré en arborescence est un filtre miroir en quadrature, et ledit filtre du type par transformée est un filtre par transformée en cosinus discrète modifiée.

4. Procédé conformément à la revendication 2, dans lequel le filtre structuré en arborescence est un filtre miroir en quadrature, et ledit filtre du type par transformée est un filtre par transformée de Fourier discrète.

5. Procédé conformément à la revendication 1, dans lequel la métrique de tonalité est générée à partir d'une mesure de cohérence.

6. Procédé conformément à la revendication 5, dans lequel la mesure de cohérence repose sur une prédiction, calculée en coordonnées polaires sur le plan complexe d'un coefficient de fréquence à un temps particulier, la mesure de cohérence correspondant à la distance euclidienne entre les coefficients de fréquence réel et prédit.

7. Procédé conformément à la revendication 6, dans lequel les coefficients de fréquence correspondent aux coefficients de fréquence à l'intérieur d'une bande de fréquences.

**8.** Procédé conformément à la revendication 6, dans lequel les coefficients de fréquence correspondent aux coefficients de fréquence à l'intérieur d'un groupe de fréquences.

## FIG. 1

## FIG. 2

FIG. 3

| 24 kHz |  |  |  |  |  |  |  |  |
|---|---|---|---|---|---|---|---|---|
|  | 64 FREQUENCY LINES | 64 FREQUENCY LINES | 64 FREQUENCY LINES | 64 FREQUENCY LINES | 64 FREQUENCY LINES | 64 FREQUENCY LINES | 64 FREQUENCY LINES | 64 FREQUENCY LINES |
| 12 kHz | 64 FREQUENCY LINES | | 64 FREQUENCY LINES | | 64 FREQUENCY LINES | | 64 FREQUENCY LINES | |
| 6 kHz | 64 FREQUENCY LINES | | | | 64 FREQUENCY LINES | | | |
| 3 kHz | 128 FREQUENCY LINES | | | | | | | |

FREQUENCY →

TIME ⟶

← 1024 TIME DOMAIN SAMPLES →

## FIG. 4

ENERGY IN dB — FREQUENCY 0 TO 22.05 kHz

## FIG. 5